# EUROPEAN PATENT APPLICATION

(11) **EP 1 801 940 A1**
(43) Date of publication of application: **27.06.2007**
(21) Application number: 06254523.1
(22) Date of filing: 30.08.2006
(51) Int. Cl.: H01S 5/183

(54) **Optical data processing apparatus using vertical-cavity surface-emitting laser (VCSEL) device with large oxide-aperture**

(30) Priority: 22.12.2005 JP 2005369086
(71) Applicant: FUJI XEROX CO., LTD., Minato-ku, Tokyo (JP)
(72) Inventor: Ueki, Nobuaki, Ebina-shi, Kanagawa (JP)
(74) Representative: Hitching, Peter Matthew

(57) **Abstract**

An optical data processing apparatus includes a light source, an optical system that concentrates light from the light source to an optical data storage medium, and a mechanism that scans the concentrated laser light on the optical data storage medium, the light source includes at least one Vertical-Cavity Surface-Emitting Laser (VCSEL) device that emits laser light, the at least one VCSEL device includes an active region and a current-confined portion (32) between first (12) and second (22) mirrors that form a vertical resonator structure, and an opening (34) having a diameter equal to or larger than about 4 micrometers is formed in the current-confined portion for applying current.

## Description

### BACKGROUND

### TECHNICAL FIELD

The present invention relates to an optical data processing apparatus using a Vertical-Cavity Surface-Emitting Laser (hereinafter referred to as VCSEL) device, and more specifically relates to the use of a large-aperture VCSEL for an image forming apparatus such as a copier or printer.

### RELATED ART

A VCSEL device is a type of a laser diode, in which light is emitted from main surface side of a semiconductor substrate. VCSELs have outstanding characteristics over edge-emitting semiconductor laser devices that had been used, such as a lower driving current. Moreover, wafer-level inspection can be conducted, and VCSELs can be easily arranged two-dimensionally. Therefore, VCSELs have been used as light sources in various fields of optical data processing, for example, optical communication, or data storage or image formation by the use of light.

In a VCSEL, a current-confined structure is required to effectively control current into an active region. For current confining, two types of methods are used; a method in which a high resistance region is formed mainly by proton implantation, and a method in which a semiconductor layer that contains aluminum is selectively oxidized. In recent years, the latter has become the mainstream.

Formation of a selective oxidation type VCSEL having a refractive index waveguide structure includes; forming a post structure by etching a semiconductor substrate on which semiconductor multi-layer films are epitaxially grown, and then thermally oxidizing a semiconductor layer that contains Al from side surface of the post. Simultaneously with the formation of a high resistance region by selectively oxidizing the semiconductor layer that contains aluminum, which is a portion of the semiconductor multi-layer reflective film near the active region, refractive index of the region is reduced to act as an optical waveguide. By its strong light confining effect, a low threshold current and highly effective, excellent characteristics can be obtained.

Inner diameter of the high resistance region formed by the oxidation, that is, the diameter of a non-oxidized region affects lasing mode of laser light. To obtain a fundamental transverse mode emission (single-mode), the diameter of the non-oxidized region should be equal to or smaller than nearly 4 micrometers. If the diameter is larger than that, the lasing mode shifts to higher-order modes emission (multi-mode).

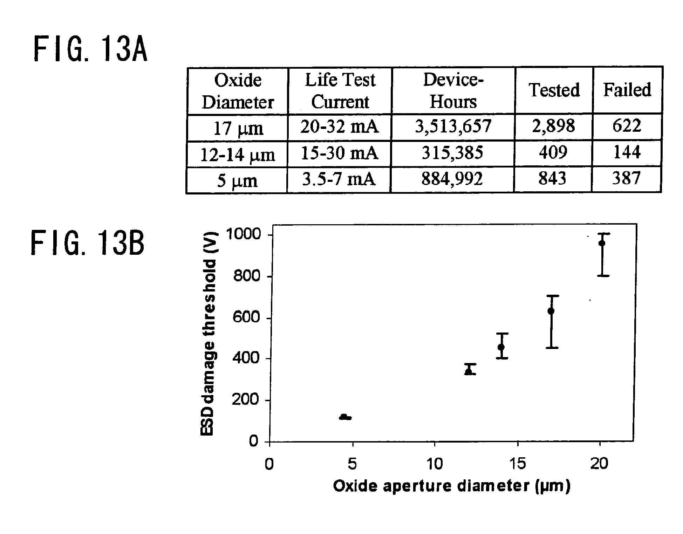

It is known that the diameter of the non-oxidized region affects not only mode lasing, but also electrostatic discharge (ESD) damage threshold or reliability. For example, according to "Reliability of Various Size Oxide Aperture VCSELs", by Bobby M. Hawkins et al., online version of Advanced Optical Components white paper, searched on the Internet on December 9, 2005, (URL: http://www.adopco.com/publication/documents/Reliabiliutyof VariousSizeOxideApertureVCSELs.pdf), the relation between the diameter of the non-oxidized region and the device hours until the device results in failure is shown as in FIG. 13A. In FIG. 13B, the relation between the diameter of the non-oxidized region and the ESD damage threshold is shown, and it can be found that the smaller the diameter of the non-oxidized region is, the lower the ESD damage threshold or reliability becomes.

On the other hand, as disclosed in Japanese Patent Application Publication No. 2002-359432, even if the diameter of non-oxidized region is equal to or more than 5 micrometers, a particular one transverse mode, i.e., single-mode, lasing can be obtained by providing surface processing on the substrate. Obtained mode is not a multi-mode lasing although it is a high-order transverse mode lasing.

### PROBLEMS TO BE SOLVED BY THE INVENTION

When a VCSEL is used as a light source of, for example, an electrophotographic image forming apparatus (scanning exposure apparatus) such as a laser printer, in order to obtain high resolution, it is required that small light-emitting spots be connected on a surface of a photoconductor drum. In other words, because it is required that the radiation light of the VCSEL be focused by a lens, a single-mode (fundamental transverse mode lasing) is preferred whose emission intensity distribution is Gaussian-like. As a result, for applications such as a high-resolution laser printer, a VCSEL in which the diameter of the non-oxidized region is equal to or smaller than nearly 4 micrometers has been used.

However, the diameter of the post portion of a VCSEL is about 20 to 30 micrometers. To form a non-oxidized region having a diameter equal to or smaller than 4 micrometers from the post structure, oxidation depth should be exactly controlled. The control requires complicated fabrication processes, which may cause wafer-to-wafer variation in diameter, and thus reduce yield.

In addition, the smaller the diameter of the non-oxidized region is, the less the ESD damage threshold and reliability become as shown above, and thus the faster the device degrades, which shortens the life. The life of the device decides the life of a product, and thus the degrading its life requires an additional cost, for example, preparing replacement parts. Therefore, it has been a cause of high cost to use a small-aperture single-mode VCSEL, whose non-oxidized region has a diameter of equal to or smaller than 4 micrometers typically, as a light source of an image forming apparatus such as a laser printer.

The present invention is provided to address the conventional issues mentioned above, and aims to provide a lower-cost optical data processing apparatus that uses a large-aperture VCSEL as a light source.

### SUMMARY

An aspect of the present invention provides an optical data processing apparatus including a light source, an optical system that concentrates light from the light source to an optical data storage medium, and a mechanism that scans the concentrated laser light on the optical data storage medium. The light source includes at least one Vertical-Cavity Surface-Emitting Laser (VCSEL) device that emits laser light, and the at least one VCSEL device includes an active region and a current-confined portion between first and second mirrors that form a vertical resonator structure. In the current-confined portion, an opening having a diameter larger than about 4 micrometers is formed for current injection. Preferably the light source includes an array on which multiple VCSEL devices are arranged, VCSEL devices are arranged in one or two dimensions at the substrate.

The current-confined portion may include semiconductor layer containing Aluminum, the opening is surrounded by an oxidized region formed by the selective oxidation of the semiconductor layer. If a plane shape of the opening is a circular, its diameter is greater than 4 micrometers. While a plane shape of the opening is rectangular, its diagonal is greater than4micrometers. In case the current-confine portion is formed in the post structure, the shape of the opening is reflected by the shape of the post structure. If the post structure is a column-shaped, the plane shape of the opening comes to the circular, while the post structure is a prism-shaped, the plane shape of the opening comes to the rectangular. Thus, the manufacturing of the current-confine portion can be easily by a large aperture of the opening, and the yield of VCSEL device can be improved, which results in the reduction of manufacturing cost.

The VCSEL device may be operated at a single-mode containing a single transverse mode. The opening of the current-confine portion exceed 4 micrometers causes multi-mode oscillation, if it is the high-order single-mode, single traverse mode can be obtained. According to this, the light source with a high output and little variation of divergence angle can be obtained. The high-order single mode is performed by forming multiple apertures or grooves in a emitting surface of VCSEL device, for example, in a contact layer of upper multiple reflecting layer.

VCSEL device may be operated at a proximity of threshold level. The diameter of the opening is greater than 4 micrometers, the injected current amount is increased and the multi mode oscillation is induced. However, by operating VCSEL device at the proximity of threshold level, the zero-order mode(fundamental transverse mode lasing) can be obtained. Additionally the variation of divergence angle is inhibited by fixing the driving current to the proximity of threshold level. In this manner, even the VCSEL with large oxide aperture, which is apt to be the multi mode lasing, the operation that is equivalent to the single-mode lasing can be achieved by controlling the driving condition and is utilized for the light source. In this case, it is also advantage that the light output of VCSEL device is higher than that of single-mode lasing VCSEL.

### ADVANTAGES OF THE INVENTION

According to an optical data processing apparatus of an example, by using a VCSEL, in which the opening of the current-confined portion is larger than about 4 micrometers, as a light source, the opening of the current-confined portion can be manufactured in an easier process, and wafer-to-wafer variation in opening diameter can be reduced, and yield can be improved. Moreover, ESD damage threshold or reliability of the opening also improves, which leads to cost reduction of an optical data processing apparatus such as a laser printer. Furthermore, by making the diameter of the opening larger, a higher light output can be obtained than that of a small-aperture VCSEL, with which only single-mode lasing can be obtained.

In general, when a selective oxidation type VCSEL in which the diameter of the non-oxidized region is larger than 4 micrometers is used, higher-order transverse modes emission occurs as the bias current increases, and thus divergence angle increases. This is because, in most case, a high-order transverse mode becomes multiple transverse modes, i.e., a multi-mode lasing. A high-order transverse mode is likely to have a wider divergence angle as its order increases. Multi-mode lasing is a kind of overlap of several transverse modes, and thus divergence angle further increases seemingly.

However, even if the diameter of the non-oxidized region is larger than 4 micrometers, by processing a laser emitting region on the surface of the substrate into a concave portion or recessed portion, a particular one transverse mode, i.e., a single-mode lasing while being a high-order transverse mode lasing, not multi-mode lasing, can be obtained.

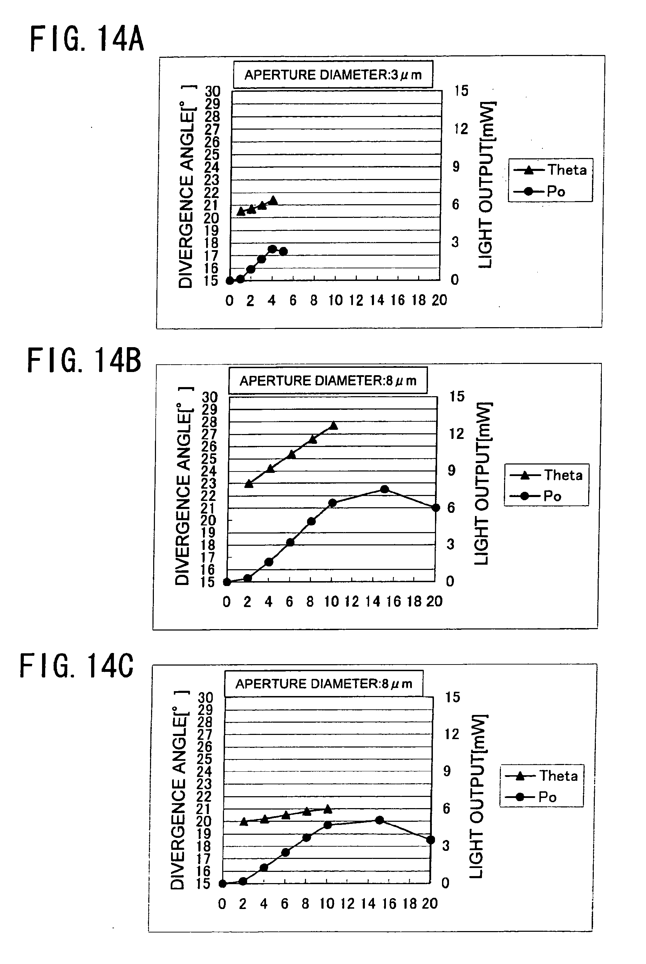

FIG. 14C shows the relation between the bias current and light output (shown by circles) and divergence angle (shown by triangles) for a VCSEL that generates a high-order single-mode lasing. For comparison, measurements obtained for a normal multi-mode VCSEL (FIG. 14B), and a single-mode VCSEL (FIG. 14A) are also shown. The diameter of the non-oxidized region of the multi-mode VCSEL is 8 micrometers, same as that of the high-order single-mode VCSEL; and that of the single-mode VCSEL is 3 micrometers.

As is evident from the measurements, the divergence angle of the high-order single-mode VCSEL is stable over a wide light output range, and its variation is as small as that of the single-mode VCSEL. For example, in FIG. 14C, the divergence angle at the time the light output starts is about 20 degrees. And the divergence angle at the time the light output reaches a peak at about 5 mW is about 21 degrees, and thus its variation is equal to or smaller than about 5%. Rather, as its opening diameter is larger than that of the single-mode VCSEL, absolute value of the divergence angle is smaller than that of the single-mode VCSEL. Therefore, it can be found that, it is possible to connect small light-emitting spots even in a high-order transverse mode lasing, as same as in the case of a fundamental transverse mode lasing.

As mentioned above, by using a high-order single-mode device, light-emitting spots with small variation can be easily obtained on the surface of a photoconductor drum. Therefore, a VCSEL that improves yield and has smaller variation in characteristics can be easily obtained, and thus a lower-cost scanning exposure apparatus can be obtained.

From the measurements described above, it also can be found that, even with a multi-mode VCSEL, the variation in divergence angle can be maintained small if the bias current rangeislimited near threshold. Therefore, even though surface processing is not provided on the substrate, single-peaked pattern emission profile can be obtained by operating the device near threshold current. This denotes the applicability of a multi-mode VCSEL to a scanning exposure apparatus.

As such, according to an optical data processing apparatus using a VCSEL of an example, by using a high-order single-mode VCSEL or a multi-mode VCSEL, either of whose non-oxidized region has a diameter of larger than 4 micrometers, and more preferably equal to or larger than 8 micrometers, as a light source, an optical data processing apparatus can be obtained in which ESD damage threshold and reliability of the device can be dramatically improved, and device-to-device variation in characteristics due to the variation in diameter of the non-oxidized region is small, all of which will lead to cost reduction.

### BRIEF DESCRIPTION OF THE DRAWINGS

Embodiments of the present invention will be described in detail based on the following figures, wherein:
FIG. 1 is a perspective view of a VCSEL according to an example of the present invention;
FIGs. 2A to 2D are cross sectional views to illustrate a method for manufacturing a VCSEL according to an example;
FIGs. 3A to 3D are cross sectional views to illustrate a method for manufacturing a VCSEL according to an example;
FIG. 4A is a plan view of a VCSEL according to an example, FIG. 4B shows an emission pattern of the VCSEL, FIG. 4C is a cross sectional view of FIG. 4A taken along line A-A;
FIG. 5 shows light output versus bias current characteristic and near-field pattern obtained with a VCSEL with holes;
FIG. 6 shows a comparison of L-I characteristics for a VCSEL with holes and a VCSEL without hole;
FIG. 7 shows lasing spectra for each of a VCSEL without hole and a VCSEL with holes;
FIG. 8A shows an example of holes formed at a top portion, and FIG. 8B shows an example of an emission pattern;
FIG. 9 shows an example of a circuit configuration for driving a VCSEL array;
FIG. 10 is a schematic view of a package on which a VCSEL array is mounted;
FIG. 11 is a schematic view of another package on which a VCSEL array is mounted;
FIG. 12 is a schematic view of an electrophotographic image forming apparatus using a large-aperture VCSEL according to an example;
FIG. 13A shows data on oxidation opening diameter and reliability, and FIG. 13B shows data on oxidation opening diameter and ESD damage threshold; and
FIG. 14A shows data on divergence angle and light output for a single-mode VCSEL, FIG. 14B shows data on divergence angle and light output for a multi-mode VCSEL, and FIG. 14C shows data on divergence angle and light output for a high-order single-mode VCSEL.

### DETAILED DESCRIPTION

A description will now be given, with reference to the accompanying drawings, of embodiments of the present invention.

Now examples of a scanning exposure apparatus using a VCSEL according to an aspect of the invention will be described referring to the accompanying drawings.

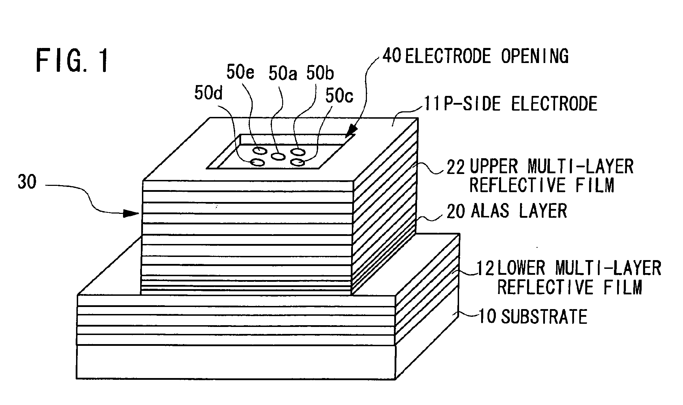

FIG. 1 is a perspective view of a VCSEL according to an example of the present invention. The VCSEL in the example includes a rectangular parallelepiped post portion 30 on a substrate 10. In an electrode opening 40 at a top portion of the post portion 30, multiple holes 50a, 50b, 50c, 50d, and 50e are formed. In an AlAs layer 20 in the post portion 30, a non-oxidized region having a diameter of about 8 micrometers is formed. A VCSEL having such a configuration emits a high-order single-mode laser light, as described later.

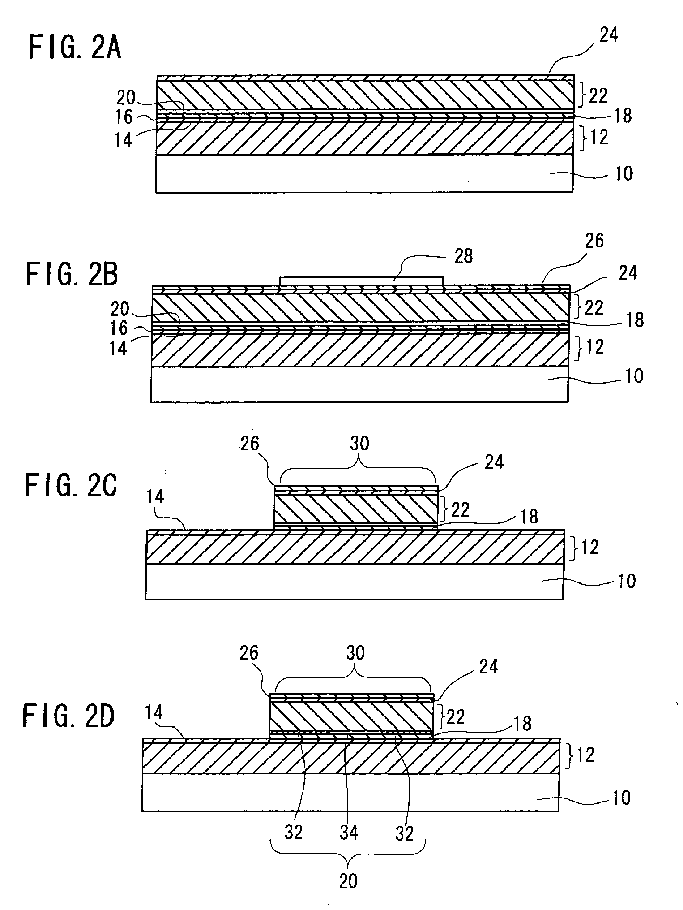

FIGs. 2A to 3D are cross sectional views to show a method for manufacturing a VCSEL shown in FIG. 1. First, as shown in FIG. 2A, by Metal Organic Chemical Vapor Deposition (MOCVD) method, on a surface (100) of an n-type GaAs substrate 10, a lower multi-layer reflective film 12 made of multi-layer stacks of n-type Al_{0.8}Ga_{0.2}As layers and n-type Al_{0.1}Ga_{0.9}As layers, a lower spacer layer 14 made of an undoped Al_{0.4}Ga_{0.6}As layer, a quantum well active region 16 that is a stack of a quantum well layer made of an undoped GaAs layer and a barrier layer made of an undoped Al_{0.2}Ga_{0.8}As layer, an upper spacer layer 18 made of an undoped Al_{0.4}Ga_{0.6}As layer, a p-type AlAs layer 20, an upper multi-layer reflective film 22 made of multi-layer stacks of p-type Al_{0.8}Ga_{0.2}As layers and p-type Al_{0.1}Ga_{0.9}As layers, and a contact layer 24 made of a p-type GaAs layer are sequentially stacked.

The thickness of each layer of the Al_{0.8}Ga_{0.2}As layer and the Al_{0.1}Ga_{0.9}As layer that form the lower multi-layer reflective film 12 and the upper multi-layer reflective film 22 is λ/4nᵣ (where λ is oscillation wavelength, nᵣ is optical refractive index of the medium). The upper multi-layer reflective film 22 is configured by adding the contact layer 24 to the topmost layer and the AlAs layer 20 to the bottommost layer.

The whole film thickness from the undersurface of the lower spacer layer 14 to the upper surface of the upper spacer layer 18 is an integral multiple of λ/nᵣ, and a standing-wave is formed therebetween. Then, so-called "antinodes" of the standing-wave, where light intensity is strongest, is designed to be at the position of the quantum well active region.

Next, as shown in FIG. 2B, after depositing SiON 26, which becomes a mask material at the time of etching, a photo-resist 28 is deposited on the upper surface of the substrate by using photolithography, and processed into a desired shape. By using this as an etching mask, a reactive ion etching is performed by using BCl₃:Cl₂ as etching gas. By etching until at least the AlAs layer 20 is exposed, a post portion 30 is formed as shown in FIG. 2C.

Then the structure is exposed to a vapor atmosphere, whose carrier gas is nitrogen (flow rate: 2 liters/min.), at 340 degrees Celsius for fifteen minutes. The AlAs layer 20 has far faster oxidation speed than that of Al_{0.8}Ga_{0.2}As layer or Al_{0.1}Ga_{0.9}As layer, main components of the uppermulti-layer reflective film. Therefore, the portion immediately above the active region is oxidized from outer peripheral portion of the post, and an insulating region (current-confined portion) 32 that corresponds to the shape of the post is formed as shown in FIG. 2D. Remained non-oxidized region 34 becomes a current-passing region. In this example, a non-oxidized region having a diameter of about 8 micrometers is formed.

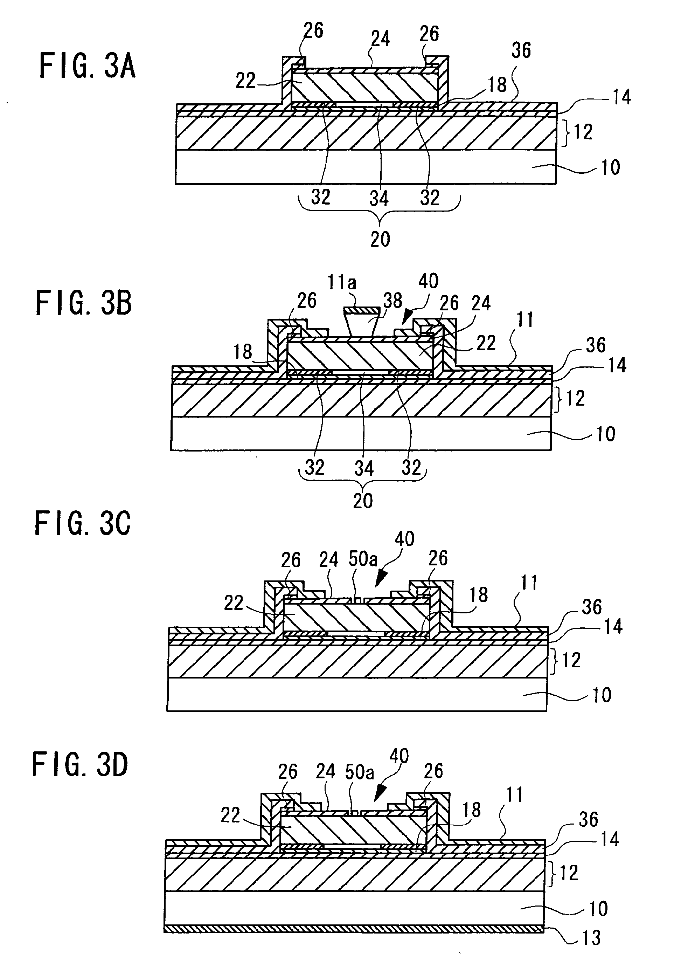

Next, as shown in FIG. 3A, after depositing SiNₓ 36 that becomes a surface protecting film, part of the SiNₓ 36 is removed together with the SiON 26 that is used as the etching mask in forming the post, and the contact layer 24 is exposed at a top portion of the post portion 30. Then as shown in FIG. 3B, a rectangular photo-resist structure 38 is formed at a center region of the top portion of the post. Then, Au, Zn, and Au are sequentially deposited by electron beam deposition from above. When the photo-resist structure 38 is removed, the Au, Zn, Au deposited on upper surface are also removed (lift-off), and an electrode opening 40 is formed together with a p-side electrode 11 at a top portion of the post.

After that, as shown in FIG. 3C, five holes 50a to 50e are formed in the electrode opening 40 by using a Focused Ion Beam (FIB) system. One hole 50a is formed on a surface of the uppermulti-layer reflective film that corresponds to the center position of the current-passing region. Other four holes 50b to 50e are formed in corner portions of the current-passing region. In this example, the diameter of each of the holes 50a to 50e is about 0.5 micrometers, and the depth is about 0.5 micrometers to reach the upper multi-layer reflective film 22.

Finally, as shown in FIG. 3D, Au-Ge/Ni/Au are deposited on the back surface side of the substrate. Then thermal processing is performed in a nitrogen atmosphere at 340 degrees Celsius for ten minutes. Resulting structure is an n-side electrode 13. This completes the formation of a VCSEL shown in FIG. 1.

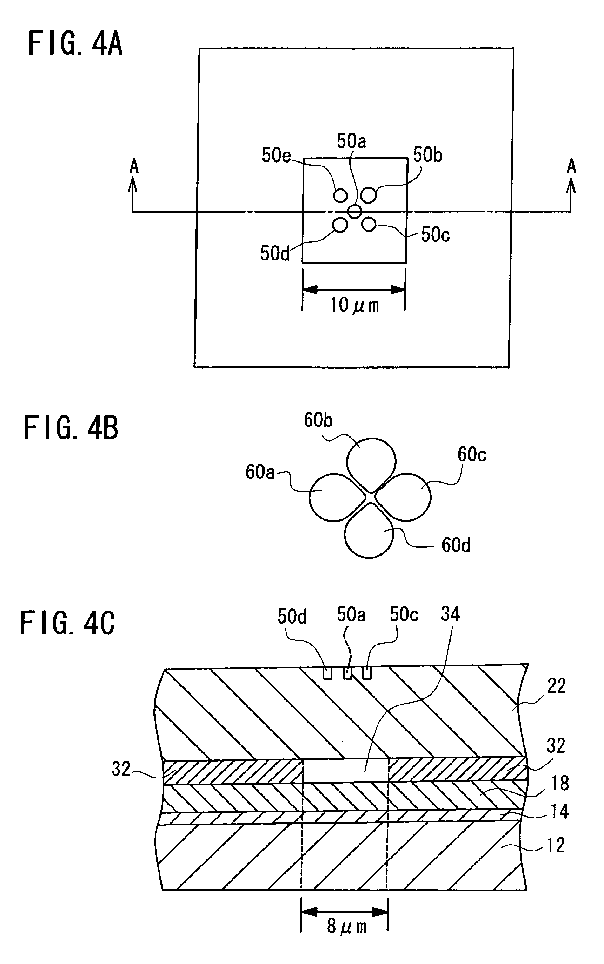

FIG. 4A is a plan view of a VCSEL. By forming five round holes 50a to 50e, four light-emitting spots 60a to 60d can be obtained as shown in FIG. 4B. FIG. 4C is a cross sectional view of a VCSEL of FIG. 4A taken along line A-A.

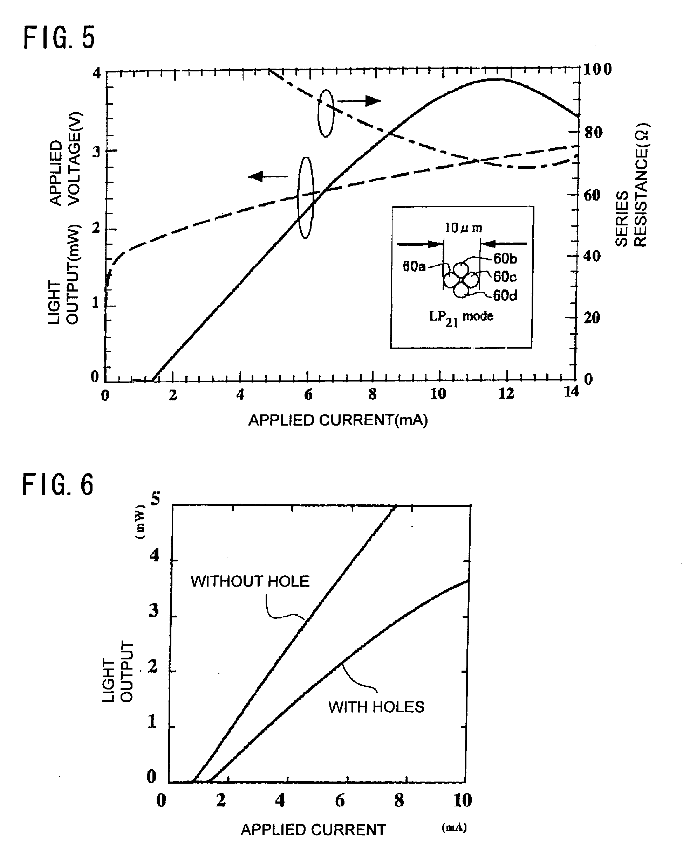

FIG. 5 shows light output versus bias current (L-I) characteristic and near-field pattern of a VCSEL provided as shown above. The solid line is for light output, and the chain line is for series resistance, and the broken line is for applied voltage. LP₂₁ mode emission that is stable can be obtained in whole injected current range, and the light output is 3.8 mW at maximum, series resistance is 80 Ω when the light output is 3 mW.

FIG. 6 shows a comparison of L-I characteristics for a VCSEL on which surface processing is not performed (hereinafter, called VCSEL without hole) and a VCSEL on which surface processing is performed to form five round holes 50a to 50e (hereinafter, called VCSEL with holes). Each of the VCSELs has a non-oxidized region 34 of the same diameter. It can be found that the surface processing increases resonator loss and threshold current, and reduces light output down to about two thirds.

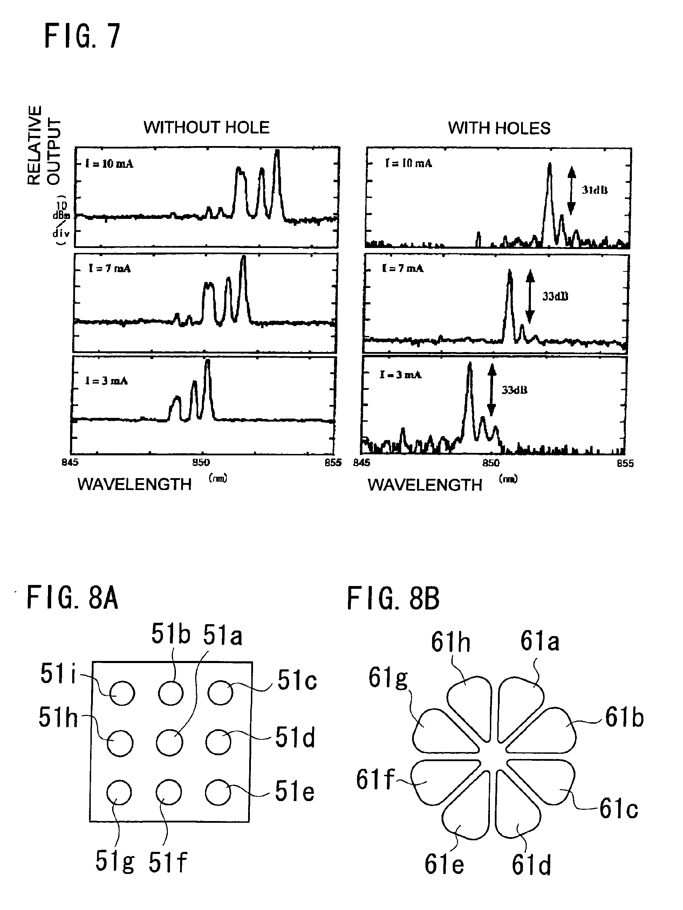

FIG. 7 shows lasing spectra when the bias current is 3 mA, 7 mA, and 10 mA, for each of a VCSEL without hole and a VCSEL with holes. For the VCSEL without hole, it can be found that the spectrum that corresponds to each mode of LP₀₁, LP₁₁, LP₂₁ is observed already at the bias current of 3 mA, and thus it provides multi-mode lasing. To the contrary, for the VCSEL with holes, it can be found that the difference of spectrum intensity between the mode of LP₁₁ and LP₂₁ with bias current of 3 mA to 10 mA exceeds 30 dB, and lasing by the LP₂₁ mode is maintained.

While in the example shown above, five holes are formed to obtain the LP₂₁ mode, in ways other than this example, other higher-order transverse modes can be obtained by changing processing pattern of the surface of the substrate. For example, as shown in FIG. 8A, by providing nine holes 51a to 51i, LP₄₁ mode made up of light-emitting spots 61a to 61h can be obtained, as shown in FIG. 8B.

The VCSEL shown in FIG. 1 is a single-spot type of laser in which one post portion (light emitter) is formed on a substrate. However, other than this example, it can be a multi-spot type VCSEL array in which multiple post portions (light emitters) are formed on a substrate. In a case a high optical output is required for a light source, multi-spot type VCSEL can be used.

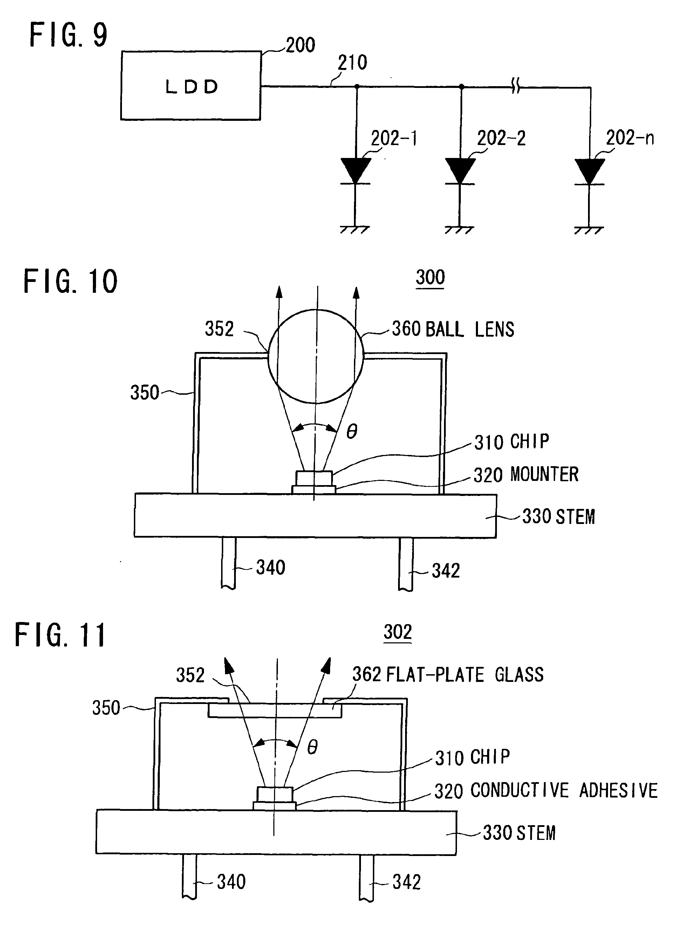

FIG. 9 shows a configuration of a circuit that drives a multi-spot type VCSEL array. Responding to an inputted driving control signal, a Laser Diode Driver (LDD) 200 provides a same driving signal 210 to multiple post portions 202-1 to 202-n formed on the substrate. The driving signal 210 is provided to a p-side electrode 11 and an n-side electrode 13 of the VCSEL. The post portions 202-1 to 202-n are driven simultaneously, and multiple laser lights are simultaneously emitted from each of electrode openings 40 at a top portion of the post in a direction vertical to the substrate. The driving signal 210 of the LDD 200 is converted into one optical signal. This signal works as one optical signal collectively and, for example, scans on the surface of a photoconductor drum, or is injected into an optical fiber or the like.

FIG. 10 is a cross sectional view showing a configuration of a package on which a VCSEL is mounted. In a package 300, a chip 310 on which a single or multiple VCSELs are formed is fixed on a disc-shaped metal stem 330, interposing a conductive adhesive 320. Conductive leads 340 and 342 are inserted into through holes (not shown) in the stem 330. One lead 340 is electrically coupled to an n-side electrode formed on the back surface of the chip 310, and the other lead 342 is electrically coupled to a p-side electrode formed on the upper surface of the chip 310, for example, via a bonding wire.

On the stem 330, a rectangular hollow cap 350 is fixed to contain the chip 310, and a ball lens 360 is fixed in a center opening of the cap 350. The optical axis of the ball lens 360 is positioned to match an approximate center of the chip 310. When a forward voltage is applied between the leads 340 and 342, laser light is emitted from the post portion of the chip 310. The distance between the chip 310 and the ball lens 360 may be adjusted so that the ball lens 360 is contained within the radiation angle θ of the laser light from the chip 310. In addition, in the cap, a light sensing device may be contained to monitor the emitting status of the VCSEL.

FIG. 11 shows a configuration of another package. In a package 302 shown in FIG. 11, instead of using the ball lens 360, a flat-plate glass 362 is fixed in a center opening the cap 350. The center of the flat-plate glass 362 is positioned to match an approximate center of the chip 310. The distance between the chip 310 and the flat-plate glass 362 may be adjusted so that the opening diameter of the flat-plate glass 362 is equal to or larger than the radiation angle θ of the laser light from the chip 310.

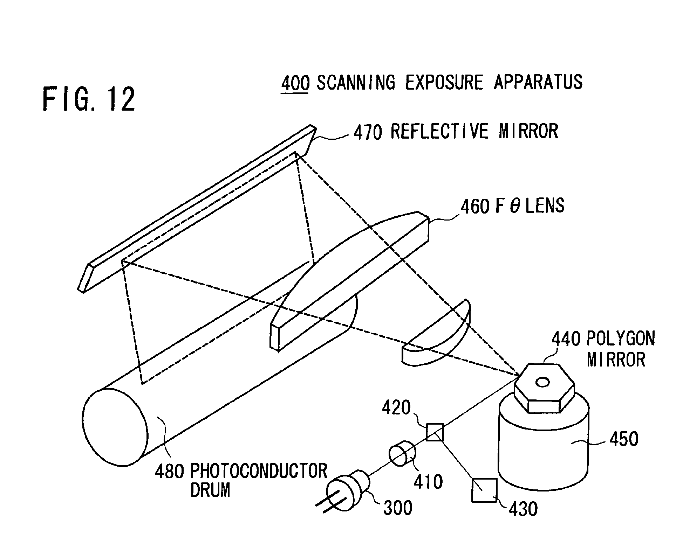

FIG. 12 is a schematic view to show a configuration of a scanning exposure apparatus 400 that forms part of an electrophotographic image forming apparatus. A VCSEL package 300 that contains a VCSEL chip is fixed to a housing (not shown), and coupled to a driving circuit. Laser light emitted from the VCSEL chip passes through a condensing optical system 410. Then the light is split by a half mirror 420 placed ahead so that part of the light is directed to a monitoring photodiode 430 and remaining light to a polygon mirror 440. The monitoring photodiode 430 detects light output value of the emitted light to monitor the emitting status of the VCSEL.

The polygon mirror 440 has a rotation motor 450 at its bottom portion, and rotates at a high speed exceeding 10000 revolutions per minute, and guides laser light to a surface of a cylinder-shaped photoconductor drum 480 through an Fθ lens 460 and a reflective mirror 470. The distortion characteristic of a general lens is expressed in the equation, *y* = *f·tanθ;* where *y* is the image height, *f* is the focal length, θ is the angle of view.

To the contrary, the lens designed so that its distortion characteristic becomes *y=f*·θ is called an Fθ lens. The laser light reflected by the polygon mirror moves in a uniform angular motion if the motor revolution is constant. However, the laser light that passes through the Fθ lens is converted such that its scanning speed becomes constant (uniform velocity motion) on the surface of the photoconductor drum.

After forming a latent image (exposure process) based on the laser light guided to the photoconductor drum 480, an electrophotographic copier, or a laser printer is achieved by undergoing each processes of developing, transferring, and fusing.

In the case a large-aperture VCSEL without hole is used, as a result of multi-mode lasing, it is inevitable that the divergence angle significantly varies together with the variation in the bias current. However, in the case of a VCSEL with holes is used, a particular transverse mode, i.e., single-mode, lasing can be obtained even though it is a high-order transverse mode lasing. This enables to make variation in divergence angle much smaller than with multi-mode lasing, and enables light spots to be stable on the surface of a photoconductor drum, and be focused into small enough.

In the example above, a VCSEL in which top portion of the post is processed to obtain a single-mode while being a high-order mode is used as a light source. However, a large-aperture VCSEL without hole, in which the surface of the electrode opening 40 is not processed, also can be used as a light source. Although operation range becomes narrow as described above, even with a normal large-aperture VCSEL in which top portion of the post is not processed, divergence angle with a small variation can be obtained if the range of bias current is limited near threshold. By operating the VCSEL at near threshold, it is possible to cause only zero-order mode (fundamental transverse mode) in laser light. This enables to obtain high light output, which is an advantage of multi-mode, while suppressing the variation in divergence angle, which is a disadvantage of multi-mode, depending on the variation in driving current. In this case, driving current of the VCSEL is controlled by the LDD 200 described above. However, the range of light output obtained in this case is limited, which is not applicable to an application that includes light intensity modulation.

The foregoing description of the examples has been provided for the purposes of illustration and description. It is not intended to be exhaustive or to limit the invention to the precise forms disclosed. It should be understood that the invention may be implemented by other methods within the scope of the invention.

According to an aspect of the invention, an optical data processing apparatus using a semiconductor laser device contributes to cost reduction of the apparatus.

## Claims

1. An optical data processing apparatus comprising:
a light source,
an optical system that concentrates light from the light source to an optical data storage medium, and
a mechanism that scans the concentrated laser light on the optical data storage medium;
wherein the light source comprising at least one Vertical-Cavity Surface-Emitting Laser device that emits laser light, the at least one VCSEL device comprising an active region and a current-confined portion between first and second mirrors that form a vertical resonator structure; and
wherein an opening having a diameter larger than about 4 micrometers is formed in the current-confined portion for current injection.

2. The optical data processing apparatus according to claim 1, wherein the light source comprises an array on which multiple VCSEL devices are arranged.

3. The optical data processing apparatus according to claim 1, wherein the current-confined portion comprises a semiconductor layer containing Al, and the opening is surrounded by a region formed by selectively oxidizing the semiconductor layer that contains Al.

4. The optical data processing apparatus according to claim 1, wherein the VCSEL device is operated with a single-mode containing a single transverse mode.

5. The optical data processing apparatus according to claim 4, wherein the VCSEL device is operated with a high-order single-mode.

6. The optical data processing apparatus according to claim 1, wherein the VCSEL device is operated at near threshold point of a lasing.

7. The optical data processing apparatus according to claim 1, wherein the first and second mirrors comprise a III-V group compound semiconductor layer containing A1, and wherein the oscillation wavelength of laser light generated in the active region is about 850 nm.

8. The optical data processing apparatus according to claim 1, wherein the light source comprises a package on which at least one VCSEL device is mounted.

9. The optical data processing apparatus according to claim 8, wherein the package comprises a lens that concentrates light emitted from the VCSEL device.

10. The optical data processing apparatus according to claim 1, wherein the optical system comprises:
a polygon mirror rotated by a motor, and
a Fθ lens; and
wherein the polygon mirror reflects laser light from the light source, and the reflected light scans on a surface of a photoconductor drum by the Fθ lens.
